# EUROPEAN PATENT SPECIFICATION

(11) **EP 3 163 759 B1**
(45) Date of publication and mention of the grant of the patent: **25.07.2018**
(21) Application number: 15191821.6
(22) Date of filing: 28.10.2015
(51) Int. Cl.: H04B 1/3816, H05K 7/14

(54) **WIFI-CARD CLAMP DEVICE OF A MODEM**
WLAN-KARTEN-KLEMMVORRICHTUNG EINES MODEMS
DISPOSITIF DE SERRAGE DE CARTE WIFI D'UN MODEM

(43) Date of publication of application: 03.05.2017
(73) Proprietor: Compal Broadband Networks Inc., 114 Taipei City (TW)
(72) Inventor: Tsai, Chia-Cheng, 300 Hsinchu City (TW); Lin, Cheng-Shan, 235 New Taipei City (TW); Wu, Chiang-Chang, 407 Taichung City (TW); Hsu, Liang-San, 247 New Taipei City (TW)
(74) Representative: Lang, Christian

(56) References cited:
- CN-U- 204 392 732
- US-A1- 2004 125 571

## Description

### BACKGROUND OF INVENTION

### 1. FIELD OF THE INVENTION

The invention relates to a WIFI-card clamp device of a modem, and more particularly to a clamp device for a modem to firmly receive a WIFI card that can be manufactured by molding or by mass production so as to avoid possible over-inserting, slackening, dislocating of a plugged card in the casing of the device.

### 2. DESCRIPTION OF THE PRIOR ART

Currently, the WIFI modem, such as a card reader, a sharer, a router and the like, is usually a device that can receive a single WIFI card in a unidirectional manner.

However, in the aforesaid design that can only receive a unidirectional insertion of a WIFI card might have at least three following shortcomings, caused by the application of the extreme thin WIFI card. The first shortcoming is that, if the manufacturing of the casing is restricted to the dimension of the receiving slot, major difficulties in molding and production would be met. The second shortcoming is that, if over-forcing to plug the WIFI card is met, the WIFI card is easy to be over-sent into the casing and is hard to be retrieved. The third shortcoming is that the possibility of slackening or dislocating for the plugged WIFI card in the casing does always exist.

Since the conventional WIFI modems do have aforesaid problems, thus an effort to improve the WIFI modems is definitely appreciated and welcome to the art.

A conventional multimedia box with a card holder is disclosed in the utility model CN 204 392 732 U.

### SUMMARY OF THE INVENTION

Accordingly, it is the primary object of the present invention to provide a WIFI-card clamp device of a modem that can guide the insert operation of a WIFI card for the modem so as to avoid possible slackening, dislocating, over-inserting of an plugged card in the casing of the device.

This object is achieved by a WIFI-card clamp device of a modem with the features of claim 1. Advantageous embodiments are subject matter of the dependent claims.

In the present invention, the WIFI-card clamp device of a modem is constructed inside a casing, in which the casing has a base plate and two lateral plates standing to opposing sides of the base plate, and in which each of the lateral plates has a receiving opening facing the base plate, and the WIFI-card clamp device is characterized in that the WIFI card clamp device further comprises two guide rails. The two guide rails are located parallel on a top surface of the base plate by preset spacing. Each of the two lateral plates has at least one reinforced arm located close to the receiving opening and protruding toward the base plate.

In one embodiment of the present invention, the at least one reinforced arm further has an oblique surface facing the base plate.

In summary, by providing the two guide rails and the accompanying reinforced arms to guide and constrain the inert operation of the WIFI card into the casing in accordance with the present invention, then possible over-inserting, slackening, dislocating of an plugged card in the casing of the device (also the modem) can be substantially reduced.

In addition, the inclusion of the receiving opening to the casing in the present invention would make possible the molding or the mass production of the modem.

### BRIEF DESCRIPTION OF THE DRAWINGS

The present invention will now be specified with reference to its preferred embodiment illustrated in the drawings, in which:
FIG.1 is a schematic exploded view of the preferred embodiment of the WIFI-card clamp device of a modem in accordance with the present invention, with a WIFI card at the right hand side of the embodiment as depicted;
FIG.2 shows again the preferred embodiment of FIG.1, with the WIFI card at the left hand side of the embodiment as depicted;
FIG.3 is an assembled perspective view of FIG.1; and
FIG.4 is a schematic cross-sectional view of FIG.3, by a line crossing the WIFI card..

### DESCRIPTION OF THE PREFERRED EMBODIMENT

The invention disclosed herein is directed to a WIFI-card clamp device of a modem. In the following description, numerous details are set forth in order to provide a thorough understanding of the present invention. It will be appreciated by one skilled in the art that variations of these specific details are possible while still achieving the results of the present invention. In other instance, well-known components are not described in detail in order not to unnecessarily obscure the present invention.

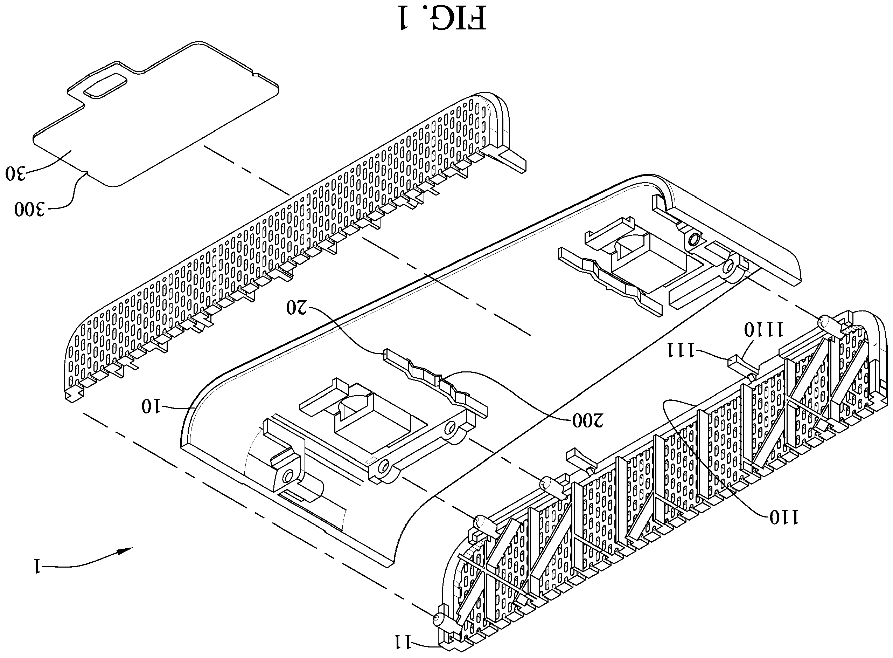

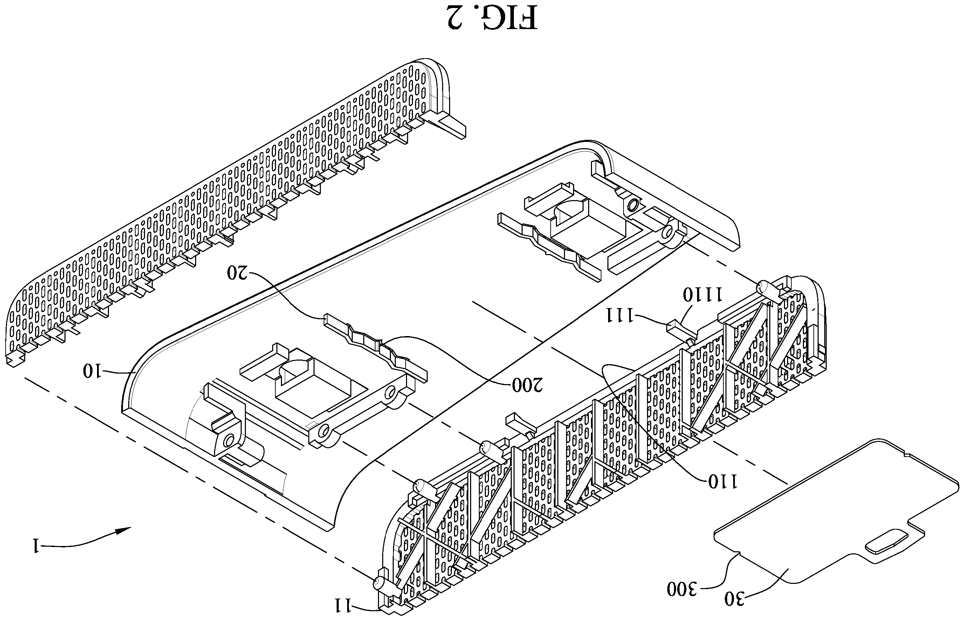

Referring now to FIG.1 and FIG.2, the preferred embodiment of the WIFI-card clamp device of a modem in accordance with the present invention is mainly constructed inside a casing 1. The casing 1 has a base plate 10 and two lateral plates 11. The two lateral plates 11 are located to opposing longitudinal sides of the base plate 10. Each of the two lateral plates 11 has a receiving opening 110 facing the base plate 10. Preferably, the receiving opening 110 is located at a lower portion of the corresponding lateral plate 11 by being parallel and close to a top surface of the base plate 10. Each of the two lateral plates 11 has at least one reinforced arm 111 (two shown in the figure) located close to the receiving opening 110 and protruding toward the base plate 10. In this embodiment, the two reinforced arms 111 are parallel located by neighboring to opposing ends of the receiving opening 110, and are extended inwards over the base plate 10. The reinforced arm 111 further has an oblique surface 1110 facing the base plate 10, and is preferably formed as an elastic part.

The WIFI card clamp device further includes two guide rails 20, located parallel on the top surface of the base plate 10 by preset spacing. Each of the two guide rails 20 has an engagement part 200 facing an internal space formed by the two guide rails 20. The engagement part 200 is particularly located at a middle place of the respective guide rail 20.

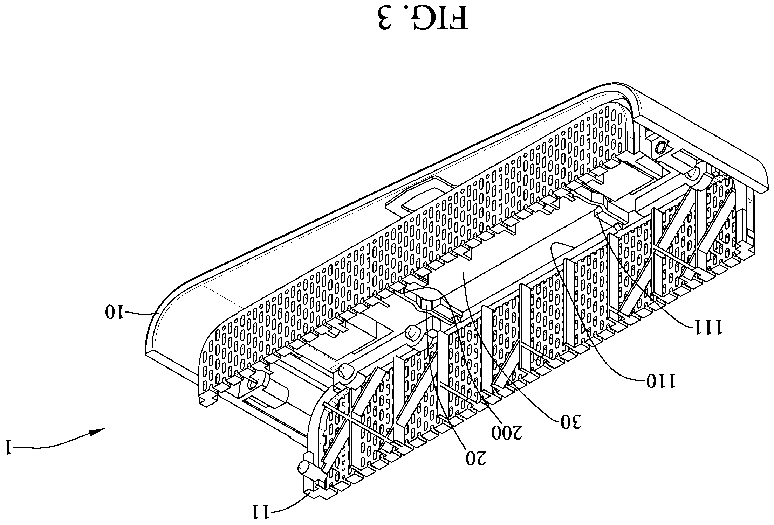

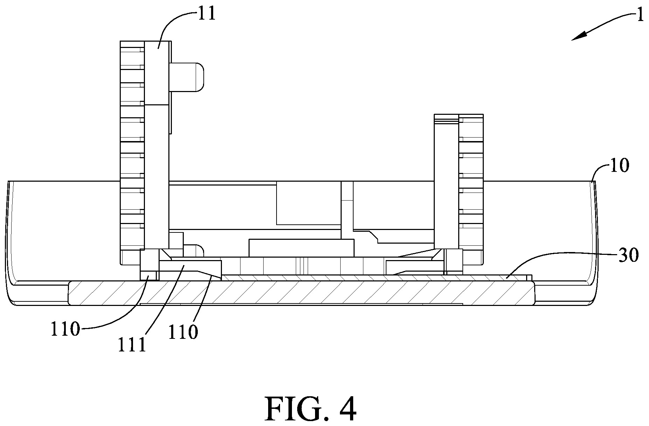

Referring now to FIG.3 and FIG.4, a WIFI card 30 is plugged into the casing 1 through the receiving opening 110 at the right hand side of the figure shown in FIG.3. While in positioning the WIFI card 30 into the casing 1, both lateral sides of the WIFI card 30 are guided, in between thereof, by the two guide rails 20 on the base plate 10, and would be smoothly slid into a predetermined position inside the casing 1 with the constraint sliding provided by the two guide rails 20.

In the case that the WIFI card 30 inside the casing 1 meets a vertical tolerance leading to up-and-down slack, then the tolerance would be compensated gradually by the restraint provided by the reinforced arms 111, precisely by sliding the tolerated WIFI card 30 along the oblique surfaces 1110 of the opposing reinforced arms 111, so as to depress the WIFI card 30 to approach the top surface of the base plate 10.

When both lateral notches 300 at the two corresponding lateral sides of the WIFI card 30 are fit into the corresponding engagement parts 200 of the two guide rails 20, the front end of the WIFI card 30 inside the casing 1 would be stopped by the free ends of the other two reinforced arms 111 protruded from the other lateral plate 11 (i.e. the lateral plate 11 at the left hand side of the figure shown in FIG.3). Upon such an arrangement, the over-inserting of the WIFI card 30 inside the casing 1 would be completely avoided.

Referring further back to FIG.2, the WIFI card 30 can be also plugged into the casing 1 through the receiving opening 110 located at the other side (i.e. the left hand side) of the casing 1. At this embodiment, the positioning of the WIFI card 30 into the casing 1 is totally resembled to the aforesaid operation, and thus details thereabout would be omitted herein.

In the present invention, by providing two opposing receiving openings 110 to opposing sides of the casing 1 for receiving WIFI cards 30, thus the WIFI card 30 to be plugged can be arbitrarily to select a relevant receiving opening 110, such that mass production and general molding can be applied to manufacturing the WIFI-card clamp device for modems.

In addition, with the free end of the reinforced arm 111 to stop the WIFI card 30 inside the casing 1 in accordance with the present invention, any possible over-inserting of the WIFI card 30 inside the casing 1 would be completely prevented.

Furthermore, with the depression of the reinforced arm 111, the sliding guide of the oblique surface 1110 and the constraint guide of the guide rails 20 in accordance with the present invention, possible slackening and dislocating happening to a conventional design for receiving the WIFI card 30 would be totally prohibited at the WIFI-card clamp device for modems as described above.

## Claims

1. A WIFI-card clamp device of a modem, constructed inside a casing (1), the casing (1) having a base plate (10) and two lateral plates (11) standing to opposing sides of the base plate (10), each of the lateral plates (11) having a receiving opening (110) facing the base plate (10), wherein the WIFI card clamp device further comprises: two guide rails (20), located parallel on a top surface of the base plate (10) by preset spacing,
**characterized in that**
each of the two lateral plates (11) has at least one reinforced arm (111) located close to the receiving opening (110) and protruding toward the base plate (10).

2. The WIFI-card clamp device of a modem of claim 1, wherein each of the two guide rails (20) has an engagement part (200) facing an internal space formed by the two guide rails (20).

3. The WIFI-card clamp device of a modem of claim 1, wherein the at least one reinforced arm (111) further has an oblique surface (1110) facing the base plate (10).

4. The WIFI-card clamp device of a modem of claim 1, wherein the reinforced arm (111) is an elastic part.

5. The WIFI-card clamp device of a modem of claim 1, wherein each of the two lateral plates (11) is furnished with two reinforced arms (111) located individually to opposing sides of the corresponding receiving opening (110), the two reinforced arms (111) protruding toward and contacting the corresponding guide rails (20).

## Patentansprüche

1. WIFI-Karten-Klemmvorrichtung eines Modems, die in einem Gehäuse (1) ausgebildet ist, wobei das Gehäuse (1) eine Basisplatte (10) und zwei laterale Platten (11) aufweist, die an gegenüberliegenden Seiten der Basisplatte (10) stehen, wobei jede der lateralen Platten (11) hat eine Aufnahmeöffnung (110) aufweist, die der Basisplatte (10) zugewandt ist, wobei die WIFI-Karten-Klemmvorrichtung im Weiteren umfasst:
zwei Führungsschienen (20), die an einer Oberseite der Basisplatte (10) mit vorgegebenem Abstand parallel angeordnet sind,
**dadurch gekennzeichnet, dass**
jeder der zwei lateralen Platten (11) zumindest einen verstärkten Arm (111) hat, der nahe der Aufnahmeöffnung (110) angeordnet ist und zu der Basisplatte (10) hin hervorsteht.

2. WIFI-Karten-Klemmvorrichtung eines Modems nach Anspruch 1, bei welcher jede der zwei Führungsschienen (20) einen Eingriffsteil (200) hat, der einem Innenraum zugewandt ist, der von den zwei Führungsschienen (20) gebildet wird.

3. WIFI-Karten-Klemmvorrichtung eines Modems nach Anspruch 1, bei welcher der zumindest eine verstärkte Arm (111) ferner eine schräge Oberfläche (1110) hat, die der Basisplatte (10) zugewandt ist.

4. WIFI-Karten-Klemmvorrichtung eines Modems nach Anspruch 1, bei welcher der verstärkte Arm (111) ein elastisches Teil ist.

5. WIFI-Karten-Klemmvorrichtung eines Modems nach Anspruch 1, bei welcher jede der beiden lateralen Platten (11) ausgestattet ist mit zwei verstärkten Armen (111), die individuell an gegenüberliegenden Seiten der entsprechenden Aufnahmeöffnung (110) angeordnet sind, wobei die beiden verstärkten Arme (111) in Richtung der entsprechenden Führungsschienen (20) hervorstehen und diese kontaktieren.

## Revendications

1. Dispositif de serrage de carte WIFI d'un modem, réalisé à l'intérieur d'un boîtier (1), le boîtier (1) comportant une plaque de base (10) et deux plaques latérales (11) se dressant sur les côtés opposés de la plaque de base (10), chacune des plaques latérales (11) comportant une ouverture de réception (110) faisant face à la plaque de base (10), dans lequel le dispositif de serrage de carte WIFI comprend en outre:
deux rails de guidage (20) placés de façon parallèle sur une surface supérieure de la plaque de base (10) selon un espacement prédéfini,
**caractérisé en ce que**
chacune des deux plaques latérales (11) comporte au moins un bras renforcé (111) placé à proximité de l'ouverture de réception (110) et faisant saillie en direction de la plaque de base (10).

2. Dispositif de serrage de carte WIFI d'un modem selon la revendication 1, dans lequel chacun des deux rails de guidage (20) comporte une pièce de mise en prise (200) faisant face à un espace interne formé par les deux rails de guidage (20).

3. Dispositif de serrage de carte WIFI d'un modem selon la revendication 1, dans lequel l'au moins un bras renforcé (111) comporte en outre une surface oblique (1110) faisant face à la plaque de base (10).

4. Dispositif de serrage de carte WIFI d'un modem selon la revendication 1, dans lequel le bras renforcé (111) est une pièce élastique.

5. Dispositif de serrage de carte WIFI d'un modem selon la revendication 1, dans lequel chacune des deux plaques latérales (11) est munie de deux bras renforcés (111) placés individuellement de part et d'autre de l'ouverture de réception (110) correspondante, les deux bras renforcés (111) faisant saillie en direction des rails de guidage (20) correspondants et faisant contact avec ceux-ci.
